(19) **Europäisches Patentamt**

**European Patent Office**

**Office européen des brevets**

(11) Veröffentlichungsnummer: **0 310 762 B1**

(12) EUROPÄISCHE PATENTSCHRIFT

(45) Veröffentlichungstag der Patentschrift: **03.03.93**

(21) Anmeldenummer: **88111798.0**

(22) Anmeldetag: **22.07.88**

(51) Int. Cl.⁵: **H01P 3/02**, G01R 29/10

(54) **Geschirmte Zelle zur Erzeugung von elektromagnetischen Wellen des TEM-Typs.**

(30) Priorität: **17.09.87 DE 3731165**

(43) Veröffentlichungstag der Anmeldung:
**12.04.89 Patentblatt 89/15**

(45) Bekanntmachung des Hinweises auf die
Patenterteilung:
**03.03.93 Patentblatt 93/09**

(84) Benannte Vertragsstaaten:
**AT CH DE LI**

(56) Entgegenhaltungen:
**US-A- 4 232 319**
**US-A- 4 507 660**
**US-A- 4 605 916**

**PROCEEDINGS OF THE IEEE, Band 73, Nr. 3, März 1985, Seiten 388-411, New York, US; M.T. MA et al.: "A review of electromagnetic compatibility/interference measurement methodologies"**

**PROCEEDINGS OF THE IEEE, Band 74, Nr. 1, Januar 1986, Seiten 120-128, IEEE, New York, US; M. KANDA et al.: "Standards for electromagnetic field measurements"**

(73) Patentinhaber: **Deutsche Aerospace Aktiengesellschaft**

**W-8000 München(DE)**

(72) Erfinder: **Nedtwig, Joachim, Dipl.-Ing.**
**Donauhalde 22**
**W-7900 Ulm 1(DE)**

(74) Vertreter: **Schulze, Harald Rudolf, Dipl.-Ing.**
**Deutsche Aerospace AG Patentabteilung**
**Postfach 17 30**
**W-7900 Ulm (DE)**

# Beschreibung

Die Erfindung betrifft eine geschirmte Zelle mit einem Wellenleiter zur Erzeugung von elektromagnetischen Wellen des transversal-elektrischen Typs ("TEM"-Zelle) mit hoher Bandbreite gemäß dem Oberbegriff des Patentanspruchs 1.

Eine solche Zelle ist beispielsweise aus dem Artikel von D. Königstein und D. Hansen: "A New Family of TEM-Cells With Enlarged Bandwidth and Optimized Working Volume", 7th Intern. Zürich Symp. on EMC (1987), Seiten 127 bis 132 bekannt.

In handelsüblichen geschirmten Räumen, beispielsweise für EMV-Messungen, treten im allgemeinen störende Feldstärkeschwankungen in Abhängigkeit vom Meßort, von der Meßfrequenz und von der Größe des Raumes auf.

Hervorgerufen werden diese Schwankungen beispielsweise dadurch, daß die auf die metallischen ebenen Wände einer geschirmten Kammer auftreffenden elektromagnetischen Wellen von den zur Abschirmung vorgesehenen Metallblechen beinahe ideal reflektiert werden. Die Räume werden daher üblicherweise an geeigneten Stellen mit elektromagnetische Wellen absorbierenden Körpern ausgerüstet. Aus Raumnutzungs- und Kostengründen werden hierzu meist mittelgroße pyramidenförmige Absorber von ca. 1 m Länge aus mit Kohlenstoffpartikeln getränktem Polyurethanschaum (PU) verwendet.

Die Absorptionsdämpfung dieser Pyramidenabsorber beträgt bei Frequenzen unterhalb 100 MHz allerdings nur wenige dB, so daß mit diesen Absorbern bei diesen Frequenzen die störenden Wandreflexionen der elektromagnetischen Wellen nicht verhindert werden können.

Hinzu kommt das Problem, daß viele Kammern parallele Wände aufweisen, die die elektromagnetischen Wellen gewissermaßen bis ins Unendliche hin- und herreflektieren und sich somit wie ein Hohlraumresonator verhalten. Insbesondere in quaderförmigen geschirmten Kammern kommt es daher trotz der Auskleidung mit Absorbern im Frequenzbereich unterhalb ca. 100 MHz zur Ausbildung ausgeprägter "stehender Wellen" bei bestimmten Resonanzfrequenzen $f_{RES}$ mit Minima-Maxima-Unterschieden in der Feldstärke bis zu 60 dB.

Eine weitere Unzulänglichkeit bei EMV-Messungen sind die Antennen. In der Realität werden die Testobjekte sehr häufig von ebenen Wellenfronten beaufschlagt. Dies gelingt in geschirmten EMV-Räumen bei niedrigen und mittleren Frequenzen (0 bis 1000 MHz) im allgemeinen nur sehr unvollkommen.

Geschirmte TEM-Zellen erzeugen elektromagnetische Wellen des transversal-elektrischen Typs bis zu einer unteren Grenzfrequenz $f_c$, von der ab höhere (störende) Wellentypen in der Zelle ausbreitungsfähig sind.

Die TEM-Welle besitzt nur Feldkomponenten in der Transversalebene der Leitungsstruktur, während die höheren Wellentypen auch Feldkomponenten in Achsrichtung der Leitungsstruktur besitzen. Wie bei Hohlleiterwellen unterscheidet man hierbei zwischen H- und E-Wellen (TE- und TM-Wellen), je nachdem, ob in der Achsrichtung eine magnetische oder elektrische Feldkomponente auftritt.

Es wurde bereits eine TEM-Zelle mit symmetrischem Wellenleiter ("Mittelleiter") vorgeschlagen (AEG TEM-Zellen Prospekt (1981), EMV/EMP-Zentrum Ulm), die aus zwei trichterförmigen Teilräumen besteht, die an entgegengesetzten Seiten eines quaderförmigen Teilraumes angebracht sind. Diese Zelle eignet sich besonders zur Felderzeugung im Frequenzbereich von 0 bis etwa $f_{RES}$. Sie hat jedoch Nachteile. Erstens erfolgt eine Wellentypwandlung von einer sphärischen Welle im Trichterteil zu einer ebenen Welle im Parallelplattenteil. Diese Wellentypwandlung kann zu störenden Superpositionen führen. Zweitens ist der nutzbare Frequenzbereich für TEM-Wellen durch Resonanzfrequenzen stark nach oben begrenzt, die durch den Abstand d der parallelen Platten bestimmt werden. Als Faustformel zur Bestimmung der Grenzfrequenz einer solchen TEM-Zelle gilt bei quadratischem Querschnitt die Beziehung

$$f_c \approx \frac{250 \text{ MHz}}{2 \cdot d}$$

In TEM-Zellen ist zudem unterhalb der ersten Resonanzfrequenz nur dann eine störungsfreie Messung möglich, wenn keine störenden Wechselwirkungen zwischen Testobjekt und Leitungsstruktur auftreten. Diese Forderung begrenzt die ausnutzbare Testhöhe bei TEM-Zellen mit symmetrischem Mittelleiter auf 1/3 bis 1/2 des Plattenabstandes d.

Trotz dieser Nachteile werden solche TEM-Zellen überall dort mit Vorteil eingesetzt, wo es in erster Linie darauf ankommt, den Prüfling flächenhaft mit einer ebenen Wellenfront zu beaufschlagen.

Soll hingegen in erster Linie der Raum innerhalb der Schirmwände optimal ausgenutzt werden, wird man den Mittelleiter möglichst dünn machen und ihn unsymmetrisch (möglichst nahe an der oberen Schirmwand der Zelle) führen. Durch diese unsymmetrische Führung des Mittelleiters in der Zelle verliert man im Meßort zwar an Feldintensität, gewinnt aber an nutzbarem Testvolumen. Die Feldbilder der TEM-Welle und der höheren, ausbreitungsfähigen Wellentypen bleiben dabei bis auf die Unsymmetrie prinzipiell erhalten, jedoch ändern sich die Grenzfrequenzen der höheren Wellentypen.

Um eine solche geschirmte Zelle mit unsymmetrischem Wellenleiter breitbandig, d. h. auch oberhalb der Grenzfrequenzen höherer Wellentypen betreiben zu können, sind die folgenden Bedingungen zu erfüllen:

a) Die Wellenanregung ist so auszubilden, daß sich nur die TEM-Welle ausbreitet.

b) Die Raumstruktur ist so zu wählen, daß keine Leitungsstörung auftritt, an der höhere Wellentypen angeregt werden können.

c) Der Leitungsabschluß muß im gesamten Frequenzbereich reflexionsfrei an die Leitung angepaßt werden.

Die Anforderungen führen zwangsläufig auf eine trichterförmige Raumstruktur, wie sie beispielsweise in dem eingangs zitierten Artikel von D. Königstein und D. Hansen beschrieben ist.

In dieser Zelle wird die Wellenanregung an der Spitze des Trichters vorgenommen, da hier der Zellenquerschnitt am geringsten ist und entsprechend die Grenzfrequenzen der störenden höheren Wellentypen am höchsten sind. Die dort erzeugte sphärische TEM-Welle läuft von dort bis zum Trichterende, an dem die Zelle den größten Querschnitt aufweist. Dort wird die Welle von dem Mittelleiterende in einen großflächigen, das Trichterende verschließenden und als Wellenabschluß dienenden Breitbandabsorber geführt und absorbiert.

Der breitbandige Wellenabschluß besteht aus mehreren parallel geschalteten, induktionsarmen Widerständen, die die Welle bei Frequenzen bis zu einigen 100 MHz reflexionsarm abschließen. Ihnen parallel wirkt die am Abschluß angebrachte ebene Pyramiden-Absorberwand, auf die die sphärische Welle auftrifft und die besonders im Frequenzbereich oberhalb von einigen 100 MHz sehr wirksam absorbiert.

Ausgehend von diesem Stand der Technik besteht die Aufgabe der Erfindung darin, eine für EMV- und EMP-Messungen geeignete geschirmte TEM-Zelle mit unsymmetrisch geführtem Mittelleiter zu schaffen, die mit einem möglichst geringen Herstellungs- und Kostenaufwand eine möglichst große Übertragungsbandbreite in einem möglichst großen nutzbaren Innenraum der Zelle ermöglicht.

Die erfindungsgemäße Lösung dieser Aufgabe ist im Patentanspruch 1 beschrieben. Die Unteransprüche enthalten vorteilhafte Aus- und Weiterbildungen der Erfindung.

Die erfindungsgemäße Lösung besteht darin, zwei im wesentlichen gleiche, breitbandige, trichterförmige TEM-Zellen mit einem unsymmetrisch geführten Mittelleiter und offenem Trichterende in der Vertikalen um 180° gegeneinander zu verdrehen und an ihren offenen Trichterenden mit ihren Außenwänden und mit ihren Mittelleitern elektrisch und mechanisch miteinander zu einer doppelten Breitband-TEM-Zelle zu verbinden, wobei die Verbindung der Außenwände HF-dicht ausgeführt ist.

Die Vorteile einer solchen Lösung gegenüber einer herkömmlichen einzelnen Breitband-TEM-Zelle bestehen vor allem darin,

a) daß ein größerer nutzbarer Meßraum im Inneren der Zelle zur Verfügung steht;

b) daß die Metallrückwände der Einzelzellen mit dem dort zwingend erforderlichen Mikrowellenabsorbermaterial sowie die dort ebenfalls zwingend erforderliche Mehrzahl von Abschlußwiderständen eingespart werden können;

c) daß eine großflächigere Feldbeaufschlagung von Testobjekten möglich ist;

d) daß eine größere Übertragungsbandbreite (z. B. von 0 bis etwa 2 GHz) einfacher zu realisieren ist.

Im folgenden wird die Erfindung anhand der Figuren näher erläutert.
Es zeigen im einzelnen:

FIG. 1    eine vorteilhafte Ausführungsform der erfindungsgemäßen Doppel-Breitband-TEM-Zelle in der Draufsicht;

FIG. 2    die gleiche vorteilhafte Ausführungsform der erfindungsgemäßen Doppel-Breitband-TEM-Zelle im Längsschnitt;

FIG. 3    einen Ausschnitt einer vorteilhaften Ausführungsform der erfindungsgemäßen Doppel-Breitband-TEM-Zelle im Längsschnitt, die insbesondere zur Übertragung von cm-Wellen geeignet ist.

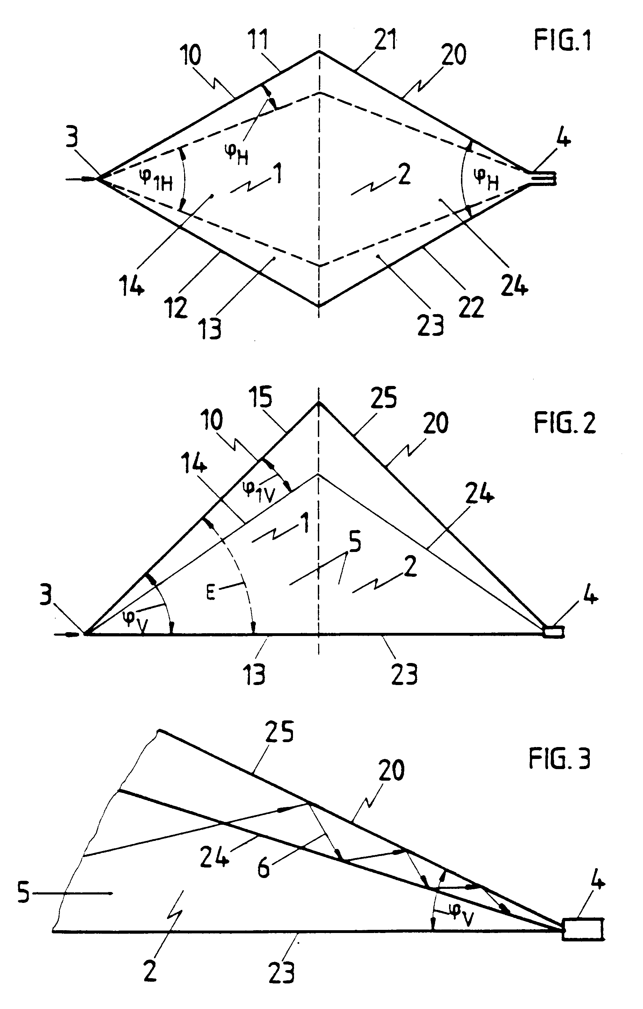

Die Ausführungsform der erfindungsgemäßen Doppel-Breitband-TEM-Zelle in den FIG. 1 und 2 besteht aus zwei im wesentlichen gleichen, trichterförmig ausgebildeten Teilzellen 1 und 2, die um 180° gegeneinander verdreht sind und an ihren offenen Trichterenden (gestrichelte Linie in den FIG. 1 und 2) mit ihren Außenwänden 11 - 13, 15 und 21 - 23, 25 und mit ihren unsymmetrisch geführten Mittelleitern 14 und 24 elektrisch und mechanisch miteinander verbunden sind. Die Verbindung der Außenwände ist dabei HF-dicht ausgeführt. Eine bevorzugte Ausführungsform dieser Zellen ist dabei für eine Übertragungsbandbreite von 0 bis etwa 2 GHz ausgelegt.

Die Zellen sind so angeordnet, daß die unteren Außenwände 13 und 23 koplanar miteinander verbunden sind und dadurch eine ebene Fläche für das nutzbare Meßvolumen 5 im Innenraum der Zelle darstellen. Die Zellen 1 und 2 sind in ihrem Querschnitt parallel zur Trichteröffnung vorzugsweise rechteckförmig oder quadratisch ausgebildet mit senkrecht stehenden seitlichen Außenwänden 11 und 12 bzw. 21 und 22. An der Trichterspitze der einen Teilzelle 1 ist eine erste Einrichtung 3 zur Erzeugung der elektromagnetischen Wellen vorgesehen, an der Trichterspitze der anderen Teilzelle 2 entsprechend eine zweite Einrichtung 4 zur Absorption der elektromagnetischen Wellen. Vorzugsweise handelt es sich bei der ersten Einrichtung 3 um einen Generator, der über einen 50-Q-Niederspannungs-/Hochspannungs-Adapter an den Mittelleiter 14, 24 angeschlossen ist, und bei der zweiten Einrichtung 4 um einen 50-Q-Hochleistungs-Breitband-Absorber, der ebenfalls an den Mittelleiter 14, 24 angeschlossen ist. Vorzugsweise ist auch der Mittelleiter als 50-Q-Leitung ausgeführt.

Der Mittelleiter 14 bzw. 24 ist so in den Teilzellen 1 bzw. 2 geführt, daß der Öffnungswinkel $\phi_{1V}$ zwischen der oberen Außenwand 15 bzw. 25 und dem Mittelleiter 14 bzw. 24 einer jeden Teilzelle 1 bzw. 2 kleiner ist als der halbe vertikale Öffnungswinkel $\phi_V$ zwischen der unteren Außenwand 13 bzw. 23 und der oberen Außenwand 15 bzw. 25 einer jeden Teilzelle 1 bzw. 2 (FIG. 2).

Der horizontale Öffnungswinkel $\phi_{1H}$ zwischen den seitlichen Berandungen des sich zum Trichterende einer jeden Teilzelle 1 bzw. 2 keilförmig verbreiternden Mittelleiters 14 bzw. 24 ist dabei kleiner als der horizontale Öffnungswinkel $\phi_H$ zwischen den seitlichen Außenwänden 11 und 12 bzw. 21 und 22 einer jeden Zelle 1 bzw. 2 (FIG. 1). Die horizontalen Öffnungswinkel $\phi_{2H}$ zwischen den seitlichen Berandungen des Mittelleiters 14 bzw. 24 und den diesen Berandungen jeweils am nächsten liegenden seitlichen Außenwänden 11 bzw. 12 bzw. 21 bzw. 22 sind dabei in etwa gleich, so daß insgesamt ein in der horizontalen Projektion (FIG. 1) symmetrisch und in der seitlich vertikalen Projektion (FIG. 2) unsymmetrisch geführter Mittelleiter 14, 24 entsteht.

Der Mittelleiter 14, 24 kann dabei aus einem dünnen Blech bestehen, das freitragend ist oder vorzugsweise mit Kunststoff-Trageseilen an der oberen Außenwand 15 bzw. 25 abnehmbar befestigt ist. Er kann aber auch aus mehreren metallischen Einzeldrähten bestehen, die zwischen der ersten und zweiten Einrichtung 3 und 4 gespannt sind und dabei in der Mittelleiter-Ebene zur Trichteröffnung einer jeden Teilzelle 1 bzw. 2 hin fächerförmig auseinanderlaufen und auf diese Weise eine flächenförmige Antenne bilden. Vorzugsweise sind auch die Drähte abnehmbar befestigt, damit sie bei anderen Messungen, bei denen ein Mittelleiter nicht benötigt wird, entfernt werden können.

Um höchsten Anforderungen an störungsfreie Messungen zu genügen, können vorteilhafterweise die Innenseiten der Außenwände mit zusätzlichen Mikrowellen-Absorbern ausgestattet werden. Vorzugsweise werden hierzu kurze pyramidenförmige Absorber aus mit Kohlenstoffpartikeln getränktem Polyurethanschaum eingesetzt.

Die erfindungsgemäße TEM-Zelle läßt sich auch im cm-Wellenbereich, beispielsweise für EMV-Messungen, einsetzen, wenn der horizontale Öffnungswinkel $\phi_H$ zwischen den seitlichen Außenwänden 11 und 12 bzw. 21 und 22 der trichterförmigen Teilzellen 1 bzw. 2 und - wie beispielhaft anhand des Ausschnitts der absorberseitigen Teilzelle 2 in FIG. 3 gezeigt der vertikale Öffnungswinkel $\phi_V$ zwischen den oberen und unteren Außenwänden 15 und 13 bzw. 25 und 23 der beiden Teilzellen 1 bzw. 2 in ihrer Größe so gewählt sind, daß Reflexionen der elektromagnetischen Wellen im wesentlichen nur in Wellenfortpflanzungsrichtung (6) erfolgen und Rückreflexionen dadurch vermieden werden.

Es versteht sich, daß die Erfindung mit fachmännischem Wissen aus- und weitergebildet bzw. abgewandelt sowie an unterschiedliche Anwendungen angepaßt werden kann, ohne daß dies an dieser Stelle näher erläutert werden müßte.

So ist es z. B. möglich, in Anwendungen, in denen es nicht so sehr auf eine möglichst große Übertragungsbandbreite ankommt, sondern auf einen eher geringen Platzbedarf, zwei Teilzellen mit abgeknickten Trichtern einzusetzen. Bei diesen Zellen sind der horizontale und der vertikale Öffnungswinkel $\phi_H$ bzw. $\phi_V$ zwischen den entsprechenden Außenwänden der Zellen an deren Trichterspitze größer als in ihrem übrigen Teil.

Weiterhin ist es möglich, daß die Trichterspitze der generatorseitigen Teilzelle als Flansch zum Anschluß eines NEMP (Nuclear-Electro-Magnetic-Pulse)-Generators ausgebildet ist.

Schließlich ist es möglich, die Konturen der Außenwände und des Mittelleiters der Teilzellen fließend ohne Ecken bzw. Kanten zu gestalten. Beispielsweise ist eine rotationssymmetrische Teilzelle mit kreisförmigem Querschnitt denkbar, deren Außenwandkontur sich an der Trichterspitze tangential von der Symmetrieachse entfernt und S-förmig nach außen geschwungen einen Trichter bildet, dessen Tangenten am Trichterende parallel zur Symmetrieachse verlaufen, so daß zwei gemäß Patentanspruch 1 zusammengesetzte gleichartige Teilzellen annähernd die Form einer Zitrone annehmen.

## Patentansprüche

1.  Geschirmte Zelle zur Erzeugung von elektromagnetischen Wellen des transversal-elektrischen Typs ("TEM"-Zelle), mit einem die Außenwand der Zelle bildenden, allseits geschlossenen, metallischen Schirm, mit einem im Innenraum der Zelle unsymmetrisch geführten Mittelleiter, mit einer ersten Einrichtung zur Erzeugung von elektromagnetischen Wellen und einer zweiten Einrichtung zur Absorption von elektromagnetischen Wellen im Innenraum der Zelle, dadurch gekennzeichnet,

- daß die geschirmte Zelle aus zwei im wesentlichen gleichen, trichterförmig ausgebildeten Teilzellen (1, 2) besteht;
- daß die zweite Teilzelle (2) gegenüber der ersten Teilzelle (1) in der Vertikalen um 180° verdreht ist;
- daß die beiden Teilzellen (1, 2) an ihren offenen Trichterenden mit ihren Außenwänden (11, 21; 12, 22; 13, 23; 15, 25) und mit ihren Mittelleitern (14, 24) elektrisch und mechanisch miteinander verbunden sind.

2. Geschirmte Zelle nach Anspruch 1, dadurch gekennzeichnet, daß die Verbindung der Außenwände (11, 21; 12, 22; 13, 23; 15, 25) der beiden Teilzellen (1, 2) HF-dicht ausgeführt ist.

3. Geschirmte Zelle nach einem der Ansprüche 1 oder 2, dadurch gekennzeichnet, daß die unteren Außenwände (13, 23) der beiden Teilzellen (1, 2) koplanar miteinander verbunden sind.

4. Geschirmte Zelle nach einem der Ansprüche 1 bis 3, dadurch gekennzeichnet, daß die Teilzellen (1, 2) im Querschnitt parallel zur Trichteröffnung rechteckförmig oder quadratisch mit senkrecht stehenden seitlichen Außenwänden (11, 12; 21, 22) ausgebildet sind.

5. Geschirmte Zelle nach Anspruch 1, dadurch gekennzeichnet, daß die erste Einrichtung (3) zur Erzeugung der elektromagnetischen Wellen in der Trichterspitze der ersten Teilzelle (1) angebracht ist und daß die zweite Einrichtung (4) zur Absorption der elektromagnetischen Wellen in der Trichterspitze der zweiten Teilzelle (2) angebracht ist.

6. Geschirmte Zelle nach Anspruch 5, dadurch gekennzeichnet, daß die erste Einrichtung (3) aus einem 50-Ω-Generator mit einem Hochspannungs-/Niederspannungs-Adapter und die zweite Einrichtung (4) aus einem 50-Ω-Hochleistungs-Breitband-Absorber besteht und daß der Mittelleiter (14, 24) ein 50-Ω-Mittelleiter ist.

7. Geschirmte Zelle nach Anspruch 1, dadurch gekennzeichnet, daß der vertikale Öffnungswinkel ($\phi_{1V}$) zwischen der oberen Außenwand (15 bzw. 25) und dem Mittelleiter (14 bzw. 24) einer jeden Teilzelle (1 bzw. 2) kleiner ist als der halbe vertikale Öffnungswinkel ($\phi_V$) zwischen der oberen Außenwand (15 bzw. 25) und der unteren Außenwand (13 bzw, 23) einer jeden Teilzelle (1 bzw. 2).

8. Geschirmte Zelle nach Anspruch 1, dadurch gekennzeichnet, daß der horizontale Öffnungswinkel ($\phi_{1H}$) zwischen den seitlichen Berandungen des sich zum Trichterende einer jeden Teilzelle (1 bzw. 2) keilförmig verbreiternden Mittelleiters (14 bzw. 24) kleiner ist als der horizontale Öffnungswinkel ($\phi_H$) zwischen den seitlichen Außenwänden (11, 12 bzw. 21, 22) einer jeden Zelle (1 bzw. 2).

9. Geschirmte Zelle nach Anspruch 8, dadurch gekennzeichnet, daß die horizontalen Öffnungswinkel ($\phi_{2H}$) zwischen den seitlichen Berandungen des Mittelleiters (14, 24) und den diesen Berandungen jeweils am nächsten liegenden seitlichen Außenwänden (11 bzw. 12 bzw. 21 bzw. 22) in etwa gleich sind.

10. Geschirmte Zelle nach einem der Ansprüche 1 und 7 bis 9, dadurch gekennzeichnet, daß der Mittelleiter (14, 24) aus mehreren, zwischen der ersten und zweiten Einrichtung (3, 4) gespannten und zum Trichterende einer jeden Teilzelle (1, 2) hin in der Mittelleiter-Ebene fächerförmig auseinanderlaufenden metallischen Einzeldrähten besteht.

11. Geschirmte Zelle nach Anspruch 10, dadurch gekennzeichnet, daß die Einzeldrähte des Mittelleiters (14, 24) abnehmbar in der Zelle befestigt sind.

12. Geschirmte Zelle nach einem der Ansprüche 1 und 7 bis 9, dadurch gekennzeichnet, daß der Mittelleiter (14, 24) aus einem dünnen Blech gefertigt ist und daß das Blech mit Kunststoff-Trageseilen abnehmbar an der oberen Außenwand (15, 25) befestigt ist.

13. Geschirmte Zelle nach einem der Ansprüche 1 bis 4, dadurch gekennzeichnet, daß die Innenseiten der Außenwände (11, 12, 13, 15; 21, 22, 23, 25) der Teilzellen (1, 2) mit zusätzlichen Absorbern ausgestattet sind.

14. Geschirmte Zelle nach Anspruch 13, dadurch gekennzeichnet, daß die zusätzlichen Absorber kurze pyramidenförmige Absorber aus mit Kohlenstoffpartikeln getränktem Polyurethanschaum sind.

15. Geschirmte Zelle nach Anspruch 1, dadurch gekennzeichnet, daß die Teilzellen (1, 2) an ihren Trichterspitzen größere horizontale und

vertikale Öffnungwinkel ($\phi_H$ bzw. $\phi_V$) zwischen den entsprechenden Außenwänden (11, 12; 21, 22 bzw. 13, 15; 23, 25) als in ihren übrigen Teilen haben.

16. Geschirmte Zelle nach Anspruch 15, dadurch gekennzeichnet, daß die Außenwände (11 - 13, 15; 21 - 23, 25) der Teilzellen (1, 2) in der Nähe ihrer Trichterspitzen abgeknickt sind.

17. Geschirmte Zelle nach Anspruch 1, dadurch gekennzeichnet, daß die Trichterspitze der einen Teilzelle (1) als Flansch zum Anschluß eines NEMP-Generators ausgebildet ist.

18. Geschirmte Zelle nach einem der Ansprüche 1 bis 4, dadurch gekennzeichnet, daß der vertikale Öffnungswinkel ($\phi_V$) zwischen der oberen Außenwand (15 bzw. 25) und der unteren Außenwand (13 bzw. 23) einer jeden Teilzelle (1 bzw. 2) sowie der horizontale Öffnungswinkel ($\phi_H$) zwischen den beiden seitlichen Außenwänden (11, 12 bzw. 21, 22) einer jeden Teilzelle (1 bzw. 2) in ihrer Größe so gewählt sind, daß Reflexionen der elektromagnetischen Wellen im wesentlichen nur in Wellenfortpflanzungsrichtung (6) möglich sind.

19. Geschirmte Zelle nach einem der Ansprüche 1 bis 18, gekennzeichnet durch ihre Dimensionierung für eine Übertragungsbandbreite von 0 bis etwa 2 GHz.

**Claims**

1. A shielded cell for the generation of electromagnetic waves of the transversal-electrical type ("TEM" cell) having a metallic shield closed on all sides and forming the outer wall of said cell, a neutral conductor running unsymmetrically in the inside of said cell, a first unit for the generation of said electromagnetic waves and a second unit for the absorption of said electromagnetic waves in the interior of said cell, characterised in that
   - said shielded cell comprises two substantially identical and funnel-shaped part-cells (1, 2);
   - said second part-cell (2) is rotated 180° in the vertical in relation to said first part-cell (1);
   - both said part-cells (1, 2) are connected at their open funnel ends both electrically and mechanically by their outer walls (11, 21; 12, 22; 13, 23; 15, 25) and by their neutral conductors (14, 24).

2. A shielded cell according to Claim 1, characterised in that the connection of said outer walls (11, 21; 12, 22; 13, 23; 15, 25) of said two part-cells (1, 2) is designed HF-tight.

3. A shielded cell according to one of Claims 1 or 2, characterised in that the lower outer walls (13, 23) of said two part-cells (1, 2) are connected to one another in coplanar fashion.

4. A shielded cell according to one of Claims 1 to 3, characterised in that said part-cells (1, 2) are designed in the cross-section parallel to the funnel opening rectangular or square with vertical lateral outer walls (11, 12; 21, 22).

5. A shielded cell according to Claim 1, characterised in that said first unit (3) for the generation of said electromagnetic waves is provided in the funnel apex of said first part-cell (1) and in that said second unit (4) for the absorption of said electromagnetic waves is provided in the funnel apex of said second part-cell (2).

6. A shielded cell according to Claim 5, characterised in that said first unit (3) comprises a 50-Q generator having a high-voltage/low-voltage adapter and said second unit (4) comprises a 50-Q high-power wide-band absorber, and in that said neutral conductor (14, 24) is a 50-Q neutral conductor.

7. A shielded cell according to Claim 1, characterised in that the vertical opening angle ($\phi_{1V}$) between said upper outer wall (15 or 25) and said neutral conductor (14 or 24) of each said part-cell (1 or 2) is lower than half the vertical opening angle ($\phi_V$) between said upper outer wall (15 or 25) and said lower outer wall (12 or 23) of each said part-cell (1 or 2).

8. A shielded cell according to Claim 1, characterised in that the horizontal opening angle ($\phi_{1H}$) between the lateral edges of said neutral conductor (14 or 24) tapering out towards the funnel end of each said part-cell (1 or 2) is lower than the horizontal opening angle ($\phi_H$) between said outer walls (11, 12 or 21, 22) of each said part-cell (1 or 2).

9. A shielded cell according to Claim 8, characterised in that the horizontal opening angle ($\phi_{2H}$) between the lateral edges of said neutral conductor (14 or 24) and said lateral outer walls (11, 12 or 21, 22) nearest to said lateral edges are approximately equal.

**10.** A shielded cell according to one of Claims 1 and 7 to 9, characterised in that said neutral conductor (14, 24) comprises several individual metallic wires strung between said first and second units (3, 4) and fanning out in the neutral conductor plane towards the funnel end of each said part-cell (1, 2).

**11.** A shielded cell according to Claim 10, characterised in that said individual wires of said neutral conductor (14, 24) are attached removably inside said cell.

**12.** A shielded cell according to one of Claims 1 and 7 to 9, characterised in that said neutral conductor (14, 24) is made up of a thin metal plate, and in that said plate is attached removably to said upper outer wall (15, 25) by means of plastic carrying ropes.

**13.** A shielded cell according to one of Claims 1 to 4, characterised in that the insides of said outer walls (11, 12, 13, 15; 21, 22, 23, 25) of said part-cells (1, 2) are provided with additional absorbers.

**14.** A shielded cell according to Claim 13, characterised in that said additional absorbers are short pyramidal absorbers made of polyurethane foam impregnated with carbon particles.

**15.** A shielded cell according to Claim 1, characterised in that said part-cells (1, 2) have at their funnel apexes larger horizontal and vertical opening angles ($\phi_H$ and $\phi_V$) between the corresponding outer walls (11, 12; 21, 22 or 13, 15; 23, 25) than in their other parts.

**16.** A shielded cell according to Claim 15, characterised in that said outer walls (11 - 13, 15; 21 - 23, 25) of said part-cells (1, 2) are bent over in the vicinities of their funnel apexes.

**17.** A shielded cell according to Claim 1, characterised in that the funnel apex of one part-cell (1) is designed as a flange for connection of an NEMP generator.

**18.** A shielded cell according to one of Claims 1 to 4, characterised in that the vertical opening angle ($\phi_V$) between said upper outer wall (15 or 25) and said lower outer wall (13 or 23) of each said part-cell (1 or 2), and the horizontal opening angle ($\phi_H$) between said two lateral outer walls (11, 12 or 21, 22) of each said part-cell (1 or 2) are selected as to their size such that reflections of said electromagnetic waves are substantially only possible in the wave propagation direction (6).

**19.** A shielded cell according to one of Claims 1 to 18, characterised by its being dimensioned for a transmission bandwidth of 0 to approx. 2 GHz.

**Revendications**

**1.** Cellule blindée pour la génération d'ondes électromagnétiques du type "TEM", avec un blindage métallique formant la paroi extérieure de la cellule et fermé de tout côté, avec un conducteur médian mené asymétriquement dans l'espace intérieur de la cellule, avec un premier dispositif pour la génération d'ondes électromagnétiques et un deuxième dispositif pour l'absorption d'ondes électromagnétiques dans l'espace intérieur de la cellule, caractérisée en ce que

- la cellule comprend deux cellules partielles (1, 2) en entonnoir identiques dans l'essentiel;
- la deuxième cellule partielle (2) est tournée à la verticale de 180° par rapport à la première cellule partielle (1);
- les deux cellules partielles (1, 2) sont reliées à leurs extrémités d'entonnoir ouvertes électriquement et mécaniquement avec leurs parois extérieures (11, 22; 13, 23; 15, 25) et leurs conducteurs médians (14, 24).

**2.** Cellule blindée selon la revendication 1, caractérisée en ce que la liaison des parois extérieures (11, 21; 12, 22; 13, 23; 15, 25) des deux cellules partielles (1, 2) est blindée H.F.

**3.** Cellule blindée selon une des revendications 1 ou 2, caractérisée en ce que les parois extérieures inférieures (13, 23) des deux cellules partielles (1, 2) sont reliées ensemble de façon coplanaire.

**4.** Cellule blindée selon l'une des revendications 1 à 3, caractérisée en ce que les cellules partielles (1, 2) dont la section est parallèle à l'ouverture de l'entonnoir, sont rectangulaires ou carrées avec des parois extérieures latérales (11, 12; 21, 22) placées à la verticale.

**5.** Cellule blindée selon la revendication 1, caractérisée en ce que le premier dispositif (3) pour la génération des ondes électromagnétiques est placé dans la pointe de l'entonnoir de la première cellule partielle (1) et que le deuxième dispositif (4) pour l'ebsorption des ondes électromagnétiques est placé dans la pointe de l'entonnoir de la deuxième cellule partielle (2).

6. Cellule blindée selon la revendication 5, caractérisée en ce que le premier dispositif (3) consiste en un générateur 50 avec un adaptateur haute tension/ basse tension et le deuxième dispositif (4) en un absorbeur large bande à haute puissance de 50 et que le conducteur médian (14, 24) est un conducteur médian de 50.

7. Cellule blindée selon la revendication 1, caractérisée en ce que l'angle d'ouverture vertical ($\phi_{1V}$) entre la paroi extérieure supérieure (15 ou 25) et le conducteur médian (14 ou 24) de chaque cellule partielle (1 ou 2) est plus petit que le demi angle d'ouverture vertical ($\phi_V$) entre la paroi extérieure supérieure (15 ou 25) de chaque cellule partielle (1 ou 2).

8. Cellule blindée selon la revendication 1, caractérisée en ce que l'angle d'ouverture horizontal ($\phi_{1H}$) entre les bordures latérales du conducteur médian (14 ou 24) s'élargissant en forme de coin vers l'extrémité de l'entonnoir de chaque cellule partielle (1 ou 2) est plus petit que l'angle d'ouverture horizontal ($\phi_H$) entre les parois extérieures latérales (11, 12 ou 21, 22) de chaque cellule (1 ou 2).

9. Cellule blindée selon la revendication 8, caractérisée en ce que les angles d'ouverture horizontaux ($\phi_{2H}$) entre les bordures latérales du conducteur médian (14, 24) et les parois extérieures (11 ou 12 ou 21 ou 22) latérales les plus proches de ces bordures sont à peu près identiques.

10. Cellule blindée selon l'une des revendications 1 à 7, caractérisée en ce que le conducteur médian (14, 24) consiste en fils métalliques séparés tendus entre le premier et le deuxième dispositif (3, 4) et s'écartant en éventail dans le plan du conducteur médian en direction de l'extrémité de l'entonnoir de chaque cellule partielle (1, 2).

11. Cellule blindée selon la revendication 10, caractérisée en ce que les fils séparés du conducteur médian (14, 24) sont fixés de façon amovible dans la cellule.

12. Cellule blindée selon l'une des revendications 1 et 7 à 9, caractérisée en ce que le conducteur médian (14, 24) consiste en une fine tôle et que la tôle est fixée de façon amovible avec des filins supports sur la paroi extérieure supérieure (15, 25).

13. Cellule blindée selon l'une des revendications 1 à 4, caractérisée en ce que les faces intérieures des parois extériqures (11, 12, 13, 15; 21, 22, 23, 25) des cellules partielles (1, 2) sont équipées d'absorbeurs additionnels.

14. Cellule blindée selon la revendication 13, caractérisée en ce que les absorbeurs additionnels sont des absorbeurs pyramidaux courts en mous se de polyuréthane imprégnée de particules de carbure.

15. Cellule blindée selon la revendication 1, caractérisée en ce que les cellules partielles (1, 2) ont sur leurs pointes d'entonnoir des angles d'ouverture horizontaux et verticaux ($\phi_H$ ou $\phi_V$) plus grands entre les parois extérieures correspondantes (11, 12; 21, 22; ou 13, 15; 23, 25) que dans leurs autres parties.

16. Cellule blindée selon la revendication 15, caractérisée en ce que les parois extérieures (11 - 13, 15; 21 - 23, 25) des cellules partielles (1, 2) sont pliées au voisinage de leurs pointes d'entonnoir.

17. Cellule blindée selon la revendication 1, caractérisée en ce que la pointe d'entonnoir de l'une des cellules partielles (1) est conçue comme bride pour le raccordement d'un générateur NEMP.

18. Cellule blindée selon l'une des revendications 1 à 4, caractérisée en ce que la grandeur de l'angle d'ouverture vertical ($\phi_V$) entre la paroi extérieure supérieure (15 ou 25) et la paroi extérieure inférieure (13 ou 23) de chaque cellule partielle (1 ou 2) ainsi que l'angle d'ouverture horizontal ($\phi_H$) entre les parois extérieures latérales 11, 12 ou 21, 22) de chaque cellule partielle (1 ou 2) est choisie de telle sorte que des réflexions des ondes électromagnétiques ne sont essentiellement possibles qu'en direction de la propagation des ondes (6).

19. Cellule blindée selon l'une des revendications 1 à 18, caractérisée en ce que son dimensionnement est prévu pour une largeur de bande de propagation de 0 à env. 2 GHz.

FIG.1

FIG.2

FIG.3